# EUROPÄISCHE PATENTSCHRIFT

(11) **EP 3 236 159 B1**
(45) Veröffentlichungstag und Bekanntmachung des Hinweises auf die Patenterteilung: **13.05.2020**
(21) Anmeldenummer: 17163489.2
(22) Anmeldetag: 29.03.2017
(51) Int. Cl.: F24C 7/08, H03K 17/97

(54) **BEDIENEINRICHTUNG FÜR EIN ELEKTROGERÄT UND ELEKTROGERÄT**
CONTROL DEVICE FOR AN ELECTRIC APPLIANCE AND ELECTRIC APPLIANCE
DISPOSITIF DE COMMANDE POUR UN APPAREIL ÉLECTRIQUE ET APPAREIL ÉLECTRIQUE

(30) Priorität: 18.04.2016 DE 102016206477
(43) Veröffentlichungstag der Anmeldung: 25.10.2017
(73) Patentinhaber: E.G.O. Elektro-Gerätebau GmbH, 75038 Oberderdingen (DE)
(72) Erfinder: Thimm, Dr. Wolfgang, 76137 Karlsruhe (DE)
(74) Vertreter: Patentanwälte Ruff, Wilhelm, Beier, Dauster & Partner mbB

(56) Entgegenhaltungen:
- EP-A1- 2 953 424
- EP-A2- 1 347 242
- CN-U- 205 018 428
- US-B1- 8 009 001
- US-B1- 9 294 659

## Beschreibung

### ANWENDUNGSGEBIET UND STAND DER TECHNIK

Die Erfindung betrifft eine Bedieneinrichtung für ein Elektrogerät sowie ein mit einer solchen Bedieneinrichtung versehenes Elektrogerät, insbesondere ein Kochfeld.

Bedieneinrichtungen für Elektrogeräte wie insbesondere Kochfelder mit einer Bedienblende, an der ein abnehmbares Bedienelement gehaltert ist, sind beispielsweise aus der DE19859105 A1 oder der EP 797227 A1 bekannt. Dabei werden die Bedienelemente mittels einer Halteeinrichtung an der Bedieneinrichtung bzw. an der Bedienblende gehaltert, wobei die Halteeinrichtung Haltemagnete unter der Bedienblende aufweist. In dem Bedienelement ist ein ferritisches oder magnetisches Element angeordnet. Durch die Magnetkraft wird das Bedienelement an der Bedieneinrichtung bzw. an der Bedienblende gehalten, ist aber gleichzeitig abnehmbar. Eine Position oder Bewegung des Bedienelements, insbesondere eine Drehung oder eine lineare Verschiebung, kann auf verschiedene Art und Weise erkannt werden, beispielsweise auch durch Magnetfeldsensoren.

Dokument EP 1 347 242 A2 beschreibt eine Bedieneinrichtung gemäß dem Oberbegriff des Anspruchs 1.

### AUFGABE UND LÖSUNG

Der Erfindung liegt die Aufgabe zugrunde, eine eingangs genannte Bedieneinrichtung sowie ein damit versehenes Elektrogerät zu schaffen, mit denen Probleme des Standes der Technik gelöst werden können und es insbesondere möglich ist, ein Bedienelement besser und mit geringerem Aufwand an einer Bedienblende eines Elektrogeräts zu haltern.

Gelöst wird diese Aufgabe durch eine Bedieneinrichtung mit den Merkmalen des Anspruchs 1 sowie durch ein mit einer solchen Bedieneinrichtung versehenes Elektrogerät mit den Merkmalen des Anspruchs 5. Vorteilhafte sowie bevorzugte Ausgestaltungen der Erfindung sind Gegenstand der weiteren Ansprüche und werden im Folgenden näher erläutert. Dabei werden manche der Merkmale nur für die Bedieneinrichtung oder nur für das Elektrogerät beschrieben. Sie sollen jedoch unabhängig davon sowohl für die Bedieneinrichtung als auch für das Elektrogerät selbständig gelten können. Der Wortlaut der Ansprüche wird durch ausdrückliche Bezugnahme zum Inhalt der Beschreibung gemacht.

Die Bedieneinrichtung weist neben dem Bedienelement und der Bedienblende eine Halteeinrichtung für das Bedienelement auf sowie Erkennungsmittel, um damit eine Position und/oder eine Bewegung des Bedienelements zu erkennen. Daraus kann dann eine Bedienung bewirkt werden, indem aus der Position und/oder der Bewegung eine von einer Bedienperson gewünschte Bedienfunktion ermittelt wird. Derartige Erkennungsmittel sind aus dem Stand der Technik bekannt und können vorteilhaft bei der vorliegenden Erfindung verwendet werden, sie sind nicht Gegenstand einer vertieften Darstellung der vorliegenden Erfindung.

Die Halteeinrichtung weist wie zuvor genannt mindestens ein ferritisches oder magnetisches Element in dem Bedienelement auf, vorteilhaft ein einziges solches Element. Des Weiteren weist die Halteeinrichtung eine Anordnung von einzelnen Haltemagneten unter der Bedienblende auf, die in einer bestimmten Anordnung vorgesehen sind. Alternativ können das ferritische oder magnetische Element auch unter der Bedienblende und die Anordnung von einzelnen Haltemagneten in dem Bedienelement vorgesehen sein, also vertauscht sein.

Erfindungsgemäß bildet die Anordnung von Haltemagneten ein sogenanntes Halbach-Array. Dies bedeutet, dass mehrere Magnete mit einer bestimmten Anordnung bzw. Ausrichtung ihrer Feldrichtung in geschlossener Ringform angeordnet sind.

Der Vorteil einer Anordnung der Haltemagnete als Halbach-Array liegt darin, dass dadurch eine Verstärkung bzw. Konzentration des magnetischen Felds auf einer Seite möglich ist, vorteilhaft durch die Bedienblende für eine verstärkte Haltewirkung des Bedienelements an der Bedienblende. Des Weiteren kann im Vergleich zu einer normalerweise symmetrischen Ausgestaltung des magnetischen Felds eines einzelnen Magneten eine Abschwächung des magnetischen Felds in der anderen Richtung erfolgen, so dass beispielsweise bei einer möglichen Störwirkung eines magnetischen Feldes in einen Bereich unterhalb der Haltemagneten bzw. weg von dem ferritischen bzw. magnetischen Element diese Störwirkung reduziert werden kann durch Verringerung des magnetischen Feldes. Die Anordnung der Haltemagnete als Halbach-Array kann verschiedenartig ausgebildet sein bzw. ein solches Halbach-Array kann verschiedenartig ausgebildet sein, wie nachfolgend noch in einzelnen Ausgestaltungen näher erläutert wird.

In Ausgestaltung der Erfindung kann sich das magnetische Feld der von den Haltemagneten als Halbach-Array gebildeten Anordnung auf der dem Bedienelement zugewandten Seite von derjenigen auf der dem ferritischen bzw. magnetischen Element abgewandten Seite unterscheiden. Der Faktor kann zwischen 1,5 und 2,5 liegen. Vorteilhaft wird die Anordnung als Halbach-Array so gewählt, dass auf der dem ferritischen bzw. magnetischen Element zugewandten Seite, also zur Bedienblende hin, eine Verstärkung des magnetischen Feldes erfolgt für die eingangs genannte verbesserte Halterung des Bedienelements.

In einer nicht erfindungsgemäße Ausgestaltung ist es möglich, dass das Halbach-Array einen mit Feldrichtung nach unten weisenden Zentral-Haltemagneten aufweist. Neben diesem Zentral-Haltemagneten ist jeweils links und rechts auf gegenüberliegenden Seiten ein Seiten-Haltemagnet angeordnet, dessen Feldrichtung jeweils weg von dem Zentral-Haltemagnet verläuft. Außen neben jedem Seiten-Haltemagnet, also auf der dem Zentral-Haltemagnet gegenüberliegenden Seite, ist jeweils ein Außen-Haltemagnet angeordnet. Dessen Feldrichtung verläuft jeweils zum ferritischen bzw. magnetischen Element bzw. zur Bedienblende hin. Somit ist die Feldrichtung zwischen dem Zentral-Haltemagneten und den Seiten-Haltemagneten um 90° verdreht. Zu den Außen-Haltemagneten ist die Feldrichtung noch einmal um 90° verdreht, so dass insgesamt die Außen-Haltemagnete eine magnetische Feldrichtung aufweisen, die entgegengesetzt zu derjenigen des Zentral-Haltemagneten verläuft.

Ein Zentral-Haltemagnet kann hier zwar größer bzw. stärker ausgebildet sein als die Seiten-Haltemagneten bzw. die Außen-Haltemagneten. Dies muss aber nicht sein und hängt insgesamt davon ab, wie die Anordnung der Haltemagnete aufgebaut ist und insbesondere auf welche Art und Weise eine magnetische Halterung für das Bedienelement vorgesehen sein soll. Soll das Bedienelement im Wesentlichen an einem Punkt gehalten werden und beispielsweise um diesen Punkt gut drehbar sein, wie aus der eingangs genannten EP 797227 A1 bekannt ist, so kann ein vergrößerter Zentral-Haltemagnet vorgesehen sein. Dann wird vorteilhaft eine überkreuzte Anordnung von zwei linearen Halbach-Arrays vorgesehen, die im Prinzip gleich aufgebaut sind aus jeweils seitlich an einen Zentral-Haltemagneten anschließenden Seiten-Haltemagnet, an dem außen jeweils ein Außenmagnet vorgesehen ist. Der Zentral-Haltemagnet ist derselbe für die beiden linearen Halbach-Arrays in Kreuzform. Dies wird nachfolgend aber noch näher erläutert. Ein Zentral-Haltemagnet kann dann 1,2 bis 3x so stark bzw. so groß sein wie die Seiten-Haltemagnete und/oder die Außen-Haltemagnete. Alternativ können alle Haltemagnete gleich stark bzw. groß sein.

In einer nicht erfindungsgemäße Ausgestaltung kann ein Halbach-Array fünf Haltemagnete aufweisen. Ein Zentral-Haltemagnet weist eine Feldrichtung zur Seite hin auf, also in einer Richtung parallel zur Bedienblende, insbesondere in Richtung zu einem von zwei Seiten-Haltemagneten, die an gegenüberliegenden Seiten des Zentral-Haltemagneten vorgesehen sind. Die Seiten-Haltemagnete wiederum weisen unterschiedliche bzw. entgegengesetzte Feldrichtungen auf, und zwar weist der Seiten-Haltemagnet, zu dem die Feldrichtung des Zentral-Haltemagneten weist, eine magnetische Feldrichtung nach unten auf. Der andere Seiten-Haltemagnet weist eine entgegengesetzte magnetische Feldrichtung hin zur Bedienblende bzw. zum ferritischen bzw. magnetischen Element auf.

An die äußere Seite der Seiten-Haltemagnete jeweils gegenüber dem Zentral-Haltemagnet sind Außen-Haltemagnete vorgesehen, die dieselbe magnetische Feldrichtung aufweisen, und zwar entgegengesetzt zu derjenigen des Zentral-Haltemagneten.

Im Prinzip wie für die andere nicht erfindungsgemäße Ausgestaltung zuvor erläutert, kann eine solche lineare Halbach-Anordnung in überkreuzter Form vorgesehen sein. Alternativ können die beiden grundsätzlichen Ausgestaltungen, wie sie zuvor erläutert worden sind, auch vorteilhaft für linear bewegbare Bedienelemente bzw. entsprechende Bedieneinrichtungen vorgesehen sein. Für einen längeren Bedienweg können Halbach-Arrays mit mehr als nur fünf Haltemagneten vorgesehen sein. Dazu kann außen neben einem Außen-Haltemagnet ein weiterer Haltemagnet vorgesehen sein, dessen magnetische Feldrichtung bei der ersten grundsätzlichen Ausgestaltung der Erfindung entgegengesetzt zu derjenigen des auf der anderen Seite liegenden Seiten-Haltemagnet ist. Ein wiederum daneben angeordneter Haltemagnet kann eine Feldrichtung entgegengesetzt zu derjenigen des Außen-Haltemagnet aufweisen. Dies kann sich dann so fortsetzen, so dass jeweils übernächst angeordnete Haltemagnete eine entgegengesetzte magnetische Feldrichtung aufweisen.

Bei der zweiten grundsätzlichen nicht erfindungsgemäßen Ausgestaltung können sich in entsprechender Form Haltemagnete in einer Richtung oder auch in beiden Richtungen außen an die Außen-Haltemagnete anschließen. Auch hier gilt, dass jeweils die übernächst angeordneten Haltemagnete eine zueinander entgegengesetzte Feldrichtung aufweisen sollten.

Bei einer nicht erfindungsgemäßen Ausgestaltung sind die Haltemagnete quaderartig ausgebildet, insbesondere würfelartig. Abgesehen von einer solchen Form kann ihre Herstellung auf bekannte Art und Weise erfolgen und aus üblicherweise dafür verwendeten Materialien. Besonders vorteilhaft werden Seltenerd-Materialien wie Neodym odgl. verwendet, die für starke Haltemagnete aber grundsätzlich bekannt sind.

Erfindungsgemäß wird durch ein Halbach-Array mit mehreren Haltemagneten in insgesamt geschlossener Ringform, beispielsweise mit acht bis einundzwanzig Haltemagneten, eine Konzentration der Magnetkraft in einem Punkt, nämlich in der Mitte des Kreisrings oberhalb der Bedienblende möglich. Dies kann insbesondere für ein eingangs genanntes Bedienelement entsprechend der EP 797227 A1 verwendet werden, welches an einer Stelle gehalten bzw. magnetisch gelagert sein soll und um einen Punkt drehbar sein soll.

Vorteilhaft können die Haltemagnete derart angeordnet und zu der Oberseite der Bedienblende und somit zum Bedienelement beabstandet sein, dass dort ein magnetisches Feld zur Halterung des Bedienelements an der Bedienblende erzeugt wird, welches in einer linienartigen Bewegungsrichtung des Bedienelements nicht gleichmäßig ist, sondern inhomogen ist bzw. Minima und Maxima aufweist. Dies kann vorteilhaft genutzt werden, um ein entlang einer Linie oder eines Bogens bewegbares Bedienelement in seiner Bewegung sozusagen zu Rastern bzw. die Bewegung haptisch so zu gestalten, als ob eine von mechanischen Bedienelementen bekannte Rastung vorhanden wäre. Eine grundsätzlich ähnliche Bedieneinrichtung für ein magnetisch gehaltenes Bedienelement ist aus der DE 102013206867 A1 bekannt, auf welche diesbezüglich ausdrücklich verwiesen wird. Bei dieser Ausgestaltung der vorliegenden Erfindung wird dann eben die magnetische Rasterung mit dem Halbach-Array bewirkt.

Mit einer solchen erfindungsgemäßen Bedieneinrichtung können zwar grundsätzlich verschiedene Elektrogeräte versehen sein, vorteilhaft ist es ein Elektro-Haushaltsgerät wie beispielsweise ein Kochfeld oder ein Herd mit einem Kochfeld. Grundsätzlich kann für ein solches Elektrogerät eine Bedienblende bevorzugt horizontal verlaufen, so dass nicht die gesamte Gewichtskraft des unter Umständen schweren Bedienelements gegen Abfallen oder Abrutschen gehalten werden muss. Bei ausreichend starken Haltemagneten bzw. einer ausreichend starken Halteeinrichtung, was gerade durch das Vorsehen mindestens eines beschriebenen Halbach-Arrays ermöglicht wird, kann aber selbst an senkrecht ausgerichteten Bedienblenden ein Bedienelement allgemein und auch für eine Bedienung ausreichend gut gehaltert werden.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### KURZBESCHREIBUNG DER ZEICHNUNGEN

Ausführungsbeispiele der Erfindung sind in den Zeichnungen schematisch dargestellt und werden im Folgenden näher erläutert. In den Zeichnungen zeigen:
- Fig. 1: eine nicht erfindungsgemäße Bedieneinrichtung bestehend aus einem Bedienelement in Form eines Drehknebels und einer Halteeinrichtung unter einem Glaskeramik-Kochfeld,
- Fig. 2: eine Draufsicht auf eine von Führungsmagneten und einem Halbach-Array gebildeten nicht erfindungsgemäße Halteeinrichtung samt Hall-Sensoren,
- Fig. 3: einen beispielhaften Bewegungsbereich des Drehknebels der Fig. 1 und 2 bzgl. der Linearbewegungen,
- Fig. 4: eine Unteransicht des Drehknebels mit einem Polkreuz, welches einen Zentralmagnet und außen angeordnete Signalmagnete enthält,
- Fig. 5: eine Abwandlung der nicht erfindungsgemäße Halteeinrichtung der Fig. 2 mit einem etwas anders ausgebildeten und angeordneten Halbach-Array,
- Fig. 6: eine erfindungsgemäße Ausgestaltung einer Halteeinrichtung ähnlich Fig. 2 mit einem ringförmigen Halbach-Array,
- Fig. 7: eine schematische Draufsicht einer alternativen nicht erfindungsgemäßen Halteeinrichtung für ein linear verschiebbares Bedienelement mit streifenförmigem Halbach-Array,
- Fig. 8: eine seitliche Ansicht des Halbach-Arrays der Fig. 7 mit Verlauf der Magnetfeldlinien und
- Fig. 9: eine Abwandlung des Halbach-Arrays aus Fig. 8.

### DETAILLIERTE BESCHREIBUNG DER AUSFÜHRUNGSBEISPIELE

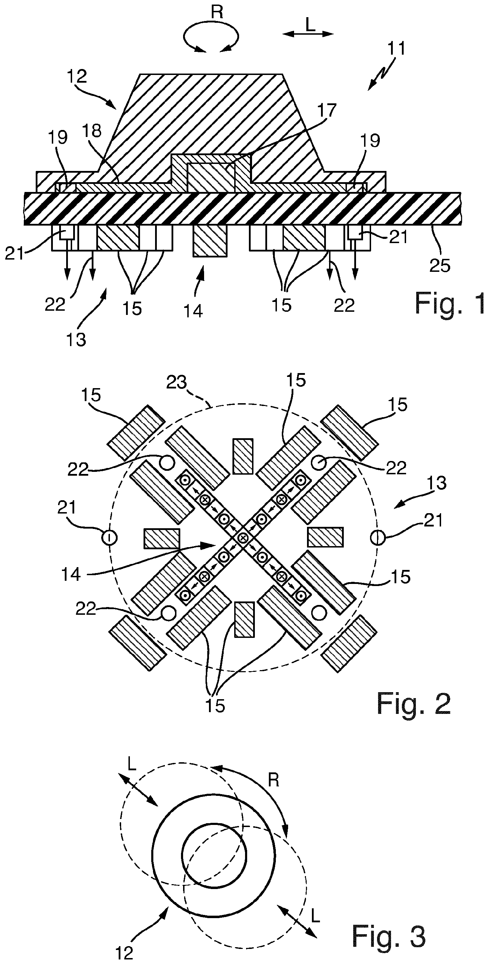

In Fig. 1 ist eine Halteeinrichtung 13 für eine Bedienrichtung 11 mit Drehknebel 12 als Bedienelement im seitlichen Schnitt dargestellt. Diese Halteeinrichtung 13 kann unter einer Glaskeramik-Kochfeldplatte 25 als Bedienblende oder unter einer sonstigen Bedienblende angeordnet sein. Bei diesem Ausführungsbeispiel kann der Drehknebel 12 abgenommen werden. Es verbleibt dann lediglich die glatte, geschlossene Oberfläche der Glaskeramik-Kochfeldplatte 25. Das entsprechende Kochfeld ist hier das mit der Bedieneinrichtung 11 bedienbare erfindungsgemäße Elektrogerät.

Dabei weist die Halteeinrichtung 13 fünfundzwanzig Haltemagnete als Halbach-Array 14 auf, das zur Halterung und Zentrierung des Drehknebels 12 dient. Des Weiteren sind mehrere Führungsmagnete 15 um das Halbach-Array 14 herum angeordnet. Diese bilden, wie deutlich aus Fig. 1 zu ersehen ist, eine kreuzförmige Linearführung für den Drehknebel 12. Die Anordnung entspricht in etwa einer Führungskulisse, wie sie auch gemäß der Erfindung für mechanische Führungen ausgebildet sein könnte, und ist grundsätzlich auch aus der vorgenannten EP 1347242 A2 bekannt. Im Wesentlichen geht es bei der Ausbildung der Halteeinrichtung 13 bzw. der Anordnung der Führungsmagnete 15 darum, eine geschlossene Umrandung mit mehreren sich längs erstreckenden Bereichen zu bilden. An jedem Ende der Längsbereiche wiederum ist jeweils ein weiterer Führungsmagnet 15 zur Begrenzung angeordnet.

Der Drehknebel 12 weist einen Zentralmagneten 17 auf, der an einem Polkreuz 18 in dem Drehknebel 12 angeordnet ist. An den Enden der Arme des Polkreuzes 18 sind Signalmagnete 19 angeordnet. Bei dem hier gezeigten Ausführungsbeispiel weist das Polkreuz 18 fünf Arme auf. Es können jedoch bei unterschiedlichen Ausgestaltungen der Erfindung auch mehr oder weniger Arme sein. Im Wesentlichen wird durch die Anzahl der Arme des Polkreuzes 18 in Verbindung mit entsprechenden Hall-Sensoren 21 zur Erfassung der Drehbewegung die Anzahl der Impulse pro Drehbewegung bestimmt.

Aus Fig. 3 ist ersichtlich, wie ein Drehknebel 12 von einer Ruheposition zentral über dem Halbach-Array 14 der Haltemagnete aus entweder mit den Linearbewegungen L linear verschoben werden kann oder darüber mit einer Radialbewegung R gedreht werden kann. Dabei ist der Drehknebel 12 gemäß dem allgemeinen Erfindungsgedanken so ausgebildet, dass er eine eingestellte Drehposition beibehält. Nach einer Linearverschiebung L kann er jedoch selbsttätig in die Ruhelage zurückkehren. Dies weist auch den Vorteil auf, dass, wie aus den Fig. 1, 2 und 4 zu ersehen ist, eine Drehbewegung R vor allem in der Ruheposition, während der Zentralmagnet 17 über dem Halbach-Array 14 ist, detektiert werden kann.

Bei einer Drehung mit Drehrichtung R in der Ruheposition ohne Linearbewegung laufen die Signalmagnete 19 auf dem gestrichelt dargestellten Drehkreis 23. Entlang dieses Drehkreises 23 sind, wie in Fig. 1 zu erkennen ist, zwei Hall-Sensoren 21 zur Erkennung einer Drehung R angeordnet. Dieses Prinzip ist ausreichend bekannt und braucht hier nicht näher erläutert zu werden.

Des Weiteren sind zwischen den Führungsmagneten 15 im äußeren Bereich der Längsbereiche weitere Hall-Sensoren 22 zur Detektierung einer Längsbewegung L angeordnet. Die Schaltsignale werden hierbei dadurch ausgelöst, dass der Zentralmagnet 17 den Anziehungsbereich über dem Halbach-Array 14 verlässt. Er wird sozusagen über einen der Längsbereiche eingebracht sowie darin entlang geführt. Sobald der Zentralmagnet 17 über einen der Hall-Sensoren 22 kommt, wird ein entsprechendes Schaltsignal ausgelöst. Dieses Schaltsignal bedeutet die Durchführung einer Linearbewegung L.

Von den Hall-Sensoren 21 und 22 gehen nicht dargestellte Leitungen zu einer nicht dargestellten Steuerung. Diese wertet die Signale der Hall-Sensoren als entsprechende Betätigung aus. Diese Steuerung kann nach bekannten Kriterien gestaltet werden, vorteilhaft weist sie einen Microcontroller auf.

Das Halbach-Array 14 und der Zentralmagnet 17 ziehen sich an, da sie gegensätzliche Polarität aufweisen. Da der Zentralmagnet 17 in dem Drehknebel 12 und die Führungsmagnete 15 dieselbe Polarität aufweisen, stoßen sie sich ab. Aus diesem Grunde ist eine gewisse Führung mit einer spürbaren Führungskraft des Zentralmagneten 17 über den von den Führungsmagneten 15 gebildeten Längsbereichen oder Kanälen möglich.

Zwar ist offensichtlich, dass die Führung des Drehknebels 12 sowohl bei einer Drehbewegung R als auch bei einer Linearbewegung L durch die Magnete nicht so stark ist, als dass sie nicht verlassen werden könnte. Allerdings kann durch Vorsehen entsprechender Magnete eine Führungskraft in ausreichender Größe erzeugt werden, die einer Bedienperson ein deutlich spürbares Gefühl für die vorgesehenen Bewegungen gibt.

Das Halbach-Array 14, um das es bei den Figuren 1 und 2 hier geht, besteht aus einer kreuzförmigen Anordnung von jeweils dreizehn Haltemagneten in einer geraden Reihe. Diese können gleiche Größe bzw. Stärke aufweisen, müssen dies aber nicht. So kann ein zentraler Haltemagnet an der Kreuzung größer bzw. stärker ausgebildet sein als die anderen. Die Polarität der einzelnen Haltemagnete des Halbach-Arrays ist eingezeichnet durch Pfeile. Dabei ist zu erkennen, dass gegenüberliegende Arme und auch benachbarte Arme gleiche Polarität aufweisen, also von innen nach außen alle Arme die gleich Anordnung der Polarität der Haltemagnete aufweisen. Die Arme reichen jeweils bis kurz vor die Hall-Sensoren 22. Andere Ausbildungen bzw. Anordnungen der Polaritäten der einzelnen Haltemagnete sind denkbar, solange sie den vorgenannten Halbach-Prinzipien folgen. Durch eine inhomogene Ausbildung eines Magnetfeldes kann eine Art Rasterung bei der Linearbewegung erreicht werden.

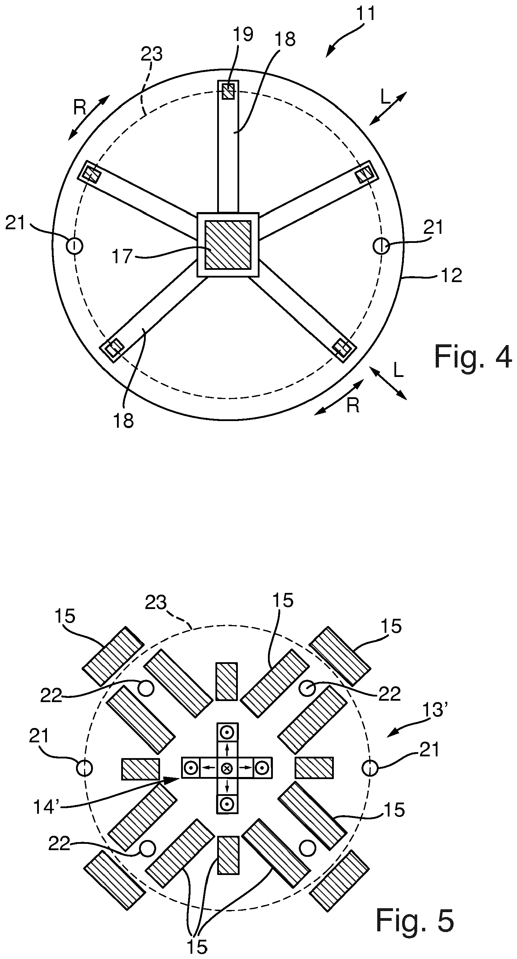

Aus der Fig. 5 geht eine alternative Ausbildung einer Bedienrichtung hervor. Die Halteeinrichtung 13' entspricht weitgehend derjenigen aus Fig. 2, nur ist hier ein Halbach-Array 14' etwas anders ausgebildet. Die neun Haltemagnete sind hier zwar auch als kreuzförmiges Halbach-Array 14' angeordnet, aber zum Einen sind die Arme kürzer als in der Fig. 2. Zum Anderen sind die Arme um 45° gegenüber der Anordnung aus Fig. 2 verdreht, so dass sie nicht zwischen die Führungsmagnete 15 laufen. Das Halbach-Array 14' dient hier also nur als Lagerung bzw. Drehlagerung.

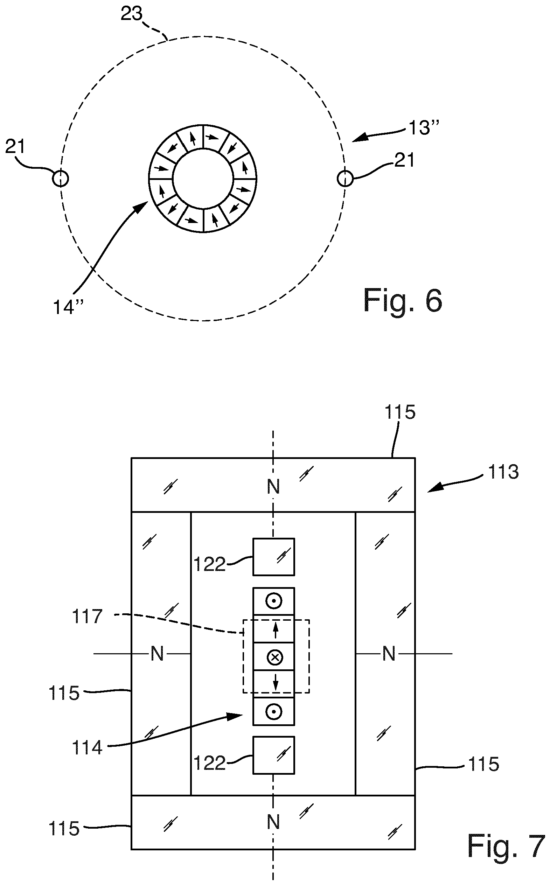

Aus der Fig. 6 geht eine Ausbildung einer erfindungsgemäßen Bedieneinrichtung hervor mit einer Halteeinrichtung 13", die ein nochmals anders ausgebildetes Halbach-Array 14" aufweist, das aus zwölf einzelnen Haltemagneten gebildet ist. Diese zwölf Haltemagnete sind ringförmig angeordnet, entweder direkt aneinander anschließend oder mit geringem Abstand zueinander. Die zwölf Haltemagnete des Halbach-Arrays 14" sind im Prinzip identisch ausgebildet oder zumindest alle gleich stark. Sie sind entsprechend dem vorgenannten Halbach-Prinzip mit ihrer jeweiligen Polung so angeordnet, dass sich zentral über ihnen ein verstärktes Magnetfeld ergibt zur besonders guten Halterung eines Drehknebels ähnlich der Fig. 1.

In Fig. 7 ist bei einer nochmals weiteren alternativen Ausbildung einer Halteeinrichtung 113 für eine nicht erfindungsgemäße Bedieneinrichtung gut zu erkennen, dass die Halteeinrichtung 113 mehrere Magnete 115 als Magnetanordnung aufweist. Dadurch wird eine hohe Haltekraft im Zentralbereich bewirkt. Mittig dazwischen ist ein längliches Halbach-Array 114 mit fünf Haltemagneten angeordnet. Zur Funktion wird auf die vorgenannte DE 19859105 A1 verwiesen. Bei dieser Bedieneinrichtung soll ein aufgesetztes Bedienelement nicht gedreht werden zur Bedienung, sondern nur linear verschoben werden als eine Art Schieberegler.

Die vier Magnete 115 der Halteeinrichtung 113 sind als Rechteckring beispielsweise auf der Oberseite einer Leiterplatte befestigt, die bei der Montage der Einrichtung unterhalb einer Bedienblende angeordnet wird. Innerhalb der äußeren Magnete 15 ist ein Halbach-Array 114 mit fünf Haltemagneten vorgesehen, gestrichelt dargestellt ist ein Zentralmagnet 117 eines darüber befindlichen Bedienelements. Die Polarität der Haltemagnete ist eben wieder als Halbach-Array ausgebildet, hier für eine Linearverschiebung. Bei dieser Linearverschiebung wird das Bedienelement mit dem Zentralmagnet 117 nahe zu einem von zwei Hall-Sensoren 122 bewegt, was diese auf bekannte Art und Weise erkennen können als Bedienung.

Bei einer derart relativ einfach ausgebildeten Halteeinrichtung 113 ist leicht vorstellbar, dass die Anordnung des Halbach-Arrays 114 auch im Bedienelement sein könnte und der gestrichelt dargestellte Zentralmagnet 117 unterhalb der Bedienblende. Dann wären sie vertauscht wie eingangs grundsätzlich beschrieben.

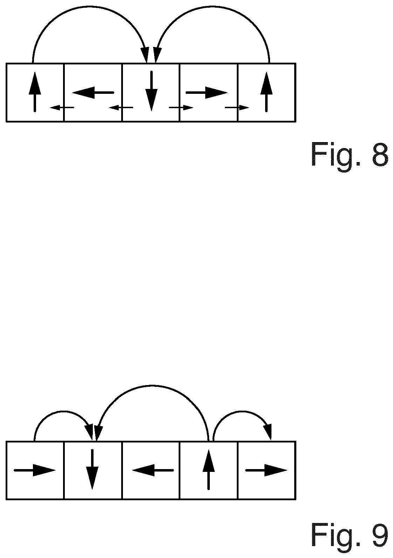

Die Fig. 8 zeigt ein Halbach-Array wie es in Fig. 7 eingebaut ist, also mit fünf Haltemagneten, von der Seite. Die eingezeichneten Feldlinien resultieren aus den Polaritäten der einzelnen Haltemagnete. Dabei ist zu beachten, dass hier zwei Magnetfeldkonzentrationen über dem Halbach-Array entstehen. Es gibt also im Prinzip zwei besonders stabile Positionen für ein Bedienelement darüber. Sind im Bedienelement zwei Magnete anstelle eines Zentralmagneten angeordnet, so kann wiederum eine einzige stabile Position geschaffen werden.

Die Fig. 9 zeigt eine Abwandlung des Halbach-Arrays aus Fig. 8. Hier sind die einzelnen Haltemagnete anders angeordnet bzw. ausgerichtet. Dadurch entstehen sozusagen gleich drei Magnetfeldkonzentrationen über dem Halbach-Array. Dies bedeutet, dass es eine stabile zentrale Position gibt und zwei weitere für eine Art Rasterung bei einer Linearbewegung.

Die Fig. 8 und 9 zeigen auch gleich die beiden eingangs genannten Möglichkeiten zur aufeinanderfolgenden Anordnung von Haltemagneten als Halbach-Array. Sie lassen sich leicht entsprechend fortsetzen wie die Fig. 2 vor allem zeigt.

## Patentansprüche

1. Bedieneinrichtung (11) für ein Elektrogerät mit einer Bedienblende (25), wobei an der Bedienblende ein abnehmbares Bedienelement (12) gehaltert ist mittels einer Halteeinrichtung (13"), wobei Erkennungsmittel (21, 22, 122) an der Bedieneinrichtung vorgesehen sind zur Erkennung einer Position und/oder Bewegung des Bedienelements (12) um daraus eine Bedienung zu bewirken, wobei die Halteeinrichtung aufweist:
- entweder ein ferritisches oder magnetisches Element (17) in dem Bedienelement (12) und eine Anordnung (14") von einzelnen Haltemagneten unter der Bedienblende (25),
- oder ein ferritisches oder magnetisches Element (17) unter der Bedienblende (25) und eine Anordnung (14") von einzelnen Haltemagneten in dem Bedienelement (12),
**dadurch gekennzeichnet, dass** die Anordnung von Haltemagneten ein Halbach-Array (14") mit mehreren Haltemagneten in geschlossener Ringform bildet.

2. Bedieneinrichtung nach Anspruch 1, **dadurch gekennzeichnet, dass** sich ein mittels des Halbach-Arrays (14") erzeugtes magnetisches Feld auf einer dem ferritischen oder magnetischen Element (17) zugewandten Seite des Halbach-Arrays von einem mittels des Halbach-Arrays erzeugten magnetischen Feld auf einer dem ferritischen oder magnetischen Element (17) abgewandten Seite des Halbach-Arrays unterscheidet.

3. Bedieneinrichtung nach Anspruch 1 oder 2, **dadurch gekennzeichnet, dass** das Halbach-Array (14") eine Anzahl von 5, 7, 9 oder 11 Haltemagneten aufweist.

4. Bedieneinrichtung nach einem der vorhergehenden Ansprüche, **dadurch gekennzeichnet, dass** die Haltemagnete des Halbach-Arrays (14") in Kreisringform angeordnet sind.

5. Elektrogerät (25) mit einer Bedieneinrichtung, **dadurch gekennzeichnet, dass** die Bedieneinrichtung (11) nach einem der vorhergehenden Ansprüche ausgebildet ist.

6. Elektrogerät nach Anspruch 5, **dadurch gekennzeichnet, dass** es ein Kochfeld mit einer Kochfeldplatte als Bedienblende (25) ist, wobei die Bedieneinrichtung (11) unter der Kochfeldplatte angeordnet ist und das Bedienelement (12) auf der Kochfeldplatte aufliegt.

## Claims

1. Control device (11) for an electric appliance with a control panel (25), wherein a removable control element (12) is retained on the control panel by means of a holding device (13"), wherein detection means (21, 22, 122) are provided on the control device for detecting a position and/or a movement of the control element (12) in order to cause an operation thereby, wherein the holding device comprises:
- either a ferritic or magnetic element (17) within the control element (12) and an arrangement (14") of individual holding magnets below the control panel (25),
- or a ferritic or magnetic element (17) below the control panel (25) and an arrangement (14") of individual holding magnets within the control element (12),
**characterized in that** the arrangement of holding magnets forms a Halbach array (14") including a plurality of holding magnets in a closed ring shape.

2. Control device according to claim 1, **characterized in that** a magnetic field generated using the Halbach array (14") on a side of the Halbach array facing the ferritic or magnetic element (17) differs from a magnetic field generated using the Halbach array on a side of the Halbach array facing away from the ferritic or magnetic element (17).

3. Control device according to claim 1 or 2, **characterized in that** the Halbach array (14") includes a number of 5, 7, 9 or 11 holding magnets.

4. Control device according to any of the preceding claims, **characterized in that** the holding magnets of the Halbach array (14") are arranged in a circular ring shape.

5. Electric appliance (25) with a control device, **characterized in that** the control device (11) is configured according to any of the preceding claims.

6. Electric appliance according to claim 5, **characterized in that** it is a cooktop having a cooktop plate for a control panel (25), wherein the control device (11) is disposed below the cooktop plate and the control element (12) rests on the cooktop plate.

## Revendications

1. Dispositif de commande (11) pour un appareil électrique comprenant un panneau de commande (25), un élément de commande amovible (12) étant fixé sur le panneau de commande au moyen d'un dispositif de retenue (13"), des moyens de détection (21, 22, 122) étant prévus sur le dispositif de commande pour détecter une position et/ou un déplacement de l'élément de commande (12) afin de lancer une commande à partir de ceux-ci, le dispositif de retenue présentant :
- soit un élément ferritique ou magnétique (17) dans l'élément de commande (12) et un agencement (14") d'aimants de retenue individuels sous le panneau de commande (25),
- soit un élément ferritique ou magnétique (17) sous le panneau de commande (25) et un agencement (14") d'aimants de retenue individuels dans l'élément de commande (12),
**caractérisé en ce que** l'agencement d'aimants de retenue forme un réseau de Halbach (14") avec plusieurs aimants de retenue sous forme annulaire fermée.

2. Dispositif de commande selon la revendication 1, **caractérisé en ce qu'**un champ magnétique généré au moyen du réseau de Halbach (14") sur un côté du réseau de Halbach tourné vers l'élément ferritique ou magnétique (17) se distingue d'un champ magnétique généré au moyen du réseau de Halbach sur un côté du réseau de Halbach opposé à l'élément ferritique ou magnétique (17).

3. Dispositif de commande selon la revendication 1 ou 2, **caractérisé en ce que** le réseau de Halbach (14") présente un nombre de 5, 7, 9 ou 11 aimants de retenue.

4. Dispositif de commande selon l'une quelconque des revendications précédentes, **caractérisé en ce que** les aimants de retenue du réseau de Halbach (14") sont disposés sous forme d'anneau circulaire.

5. Appareil électrique (25) comprenant un dispositif de commande, **caractérisé en ce que** le dispositif de commande (11) est réalisé selon l'une quelconque des revendications précédentes.

6. Appareil électrique selon la revendication 5, **caractérisé en ce qu'**il s'agit d'une table de cuisson avec une plaque de table de cuisson en tant que panneau de commande (25), le dispositif de commande (11) étant disposé sous la plaque de table de cuisson et l'élément de commande (12) reposant sur la plaque de table de cuisson.
